# FASCICULE DE BREVET EUROPEEN

(11) **EP 2 875 240 B1**
(45) Date de publication et mention de la délivrance du brevet: **07.10.2020**
(21) Numéro de dépôt: 13736594.6
(22) Date de dépôt: 15.07.2013
(51) Int. Cl.: F04C 23/00, F04B 37/14, F04C 25/02, F04C 29/00, F04F 1/00, F04F 5/00, F04C 28/02

(54) **PROCEDE ET DISPOSITIF DE POMPAGE D'UNE CHAMBRE DE PROCEDES**
VERFAHREN UND VORRICHTUNG ZUM PUMPEN EINER PROZESSKAMMER
METHOD AND DEVICE FOR PUMPING OF A PROCESS CHAMBER

(30) Priorité: 19.07.2012 FR 1202049
(43) Date de publication de la demande: 27.05.2015
(73) Titulaire: Pfeiffer Vacuum, 74000 Annecy (FR)
(72) Inventeur: SEIGEOT, Bertrand, F-74230 Dingy Saint Clair (FR)
(74) Mandataire: Croonenbroek, Thomas Jakob
(86) Numéro de dépôt international: PCT/EP2013/064929
(87) Numéro de publication internationale: WO 2014/012896

(56) Documents cités:
- WO-A1-2005/071509
- FR-A1- 2 691 382
- FR-A1- 2 952 683

## Description

### DOMAINE TECHNIQUE

La présente invention se rapporte à un dispositif de pompage comportant une pompe à vide primaire sèche pour le pompage d'une chambre de procédés, comme la chambre de procédés d'un équipement de fabrication de semi-conducteurs. La présente invention concerne également un procédé de pompage au moyen dudit dispositif de pompage.

### ETAT DE LA TECHNIQUE

Les étapes de traitement des substrats semi-conducteurs sont réalisées à basse pression dans une chambre de procédés au moyen d'un dispositif de pompage pourvu d'une pompe à vide primaire sèche. Les documents FR2952683, WO2005/071509 et FR2691382 décrivent des exemples de tels dispositifs de pompage.

Une étape préalable à l'introduction des gaz dans la chambre pour le traitement d'un substrat consiste à vérifier le seuil bas de pression atteignable en fonctionnement dit de « vide limite ». L'obtention d'une basse pression de vide limite dans la chambre de procédés est un moyen simple, rapide et peu coûteux de contrôle de l'étanchéité de la chambre, par exemple après une maintenance, ou pour vérifier que la chambre ne contient pas de résidus de gaz qui, s'ils comportent de l'oxygène ou de la vapeur d'eau en trop grande quantité par exemple, peuvent être des sources de contamination pour le substrat.

Le niveau de pression de vide limite demandé par les équipementiers est généralement de l'ordre de 10⁻³ ou 10⁻² mbar. De tels niveaux sont éloignés des pressions de procédés des substrats traités dans la chambre de procédés, habituellement comprises entre 10⁻¹ et quelques centaines de mbar.

Pour garantir l'obtention de telles pressions de vide limite puis de telles pressions de procédés situées une à deux décades plus haut, un moyen connu consiste à augmenter le nombre d'étages de pompage des pompes à vide primaires sèches pour qu'elles comportent par exemple six ou sept étages, ou à réduire les jeux de fonctionnement des pompes, ce qui dans les deux cas, augmente leur coût et tend à diminuer leur fiabilité.

D'autres dispositifs de pompage proposent d'agencer une pompe à vide monoétagée de type Roots en amont de la pompe à vide primaire sèche classique. Cependant, ces dispositifs de pompage sont également coûteux.

D'autres encore proposent d'agencer une pompe à vide auxiliaire au refoulement de la pompe à vide primaire sèche classique. La pompe à vide auxiliaire permet d'améliorer les performances du dispositif de pompage en fonctionnement de vide limite. Néanmoins, les pompes auxiliaires consomment une énergie électrique qui n'est pas négligeable et la pression de fonctionnement en vide limite peut s'avérer insuffisante.

### EXPOSE DE L'INVENTION

Un des buts de la présente invention est de proposer un dispositif de pompage qui permette d'obtenir facilement et à moindre coût une pression basse en fonctionnement de vide limite ainsi que des vitesses de pompage satisfaisantes pour le traitement des substrats à basse pression.

A cet effet, l'invention a pour objet un dispositif de pompage selon la revendication 1.

L'invention a aussi pour objet un procédé de pompage d'une chambre de procédés au moyen d'un dispositif de pompage tel que décrit précédemment raccordé à une chambre de procédés, dans lequel on réduit l'alimentation en gaz du moyen de purge de la pompe à vide primaire sèche et on abaisse la pression dans le conduit de refoulement raccordé à la sortie de la pompe à vide primaire sèche, par la mise en route de l'éjecteur lorsque la chambre de procédés est en fonctionnement de vide limite, en alimentant le moyen d'injection de gaz moteur de l'éjecteur avec le gaz du moyen de purge de la pompe à vide primaire sèche.

Selon une ou plusieurs caractéristiques du dispositif de pompage ou du procédé de pompage, prise seule ou en combinaison,
- le dispositif de pompage comporte un moyen de contrôle configuré pour contrôler le premier et le deuxième dispositifs à vanne en fonction d'un état de fonctionnement de la chambre de procédés de sorte que le premier dispositif à vanne soit au moins partiellement fermé et le deuxième dispositif à vanne soit ouvert lorsque la chambre de procédés est en fonctionnement de vide limite,
- lorsque la chambre de procédés est en fonctionnement de vide limite, le flux d'alimentation en gaz du moyen de purge est compris entre 20 et 200 sccm (ou 0,0334 et 0,334 Pa.m³/s),
- le premier dispositif à vanne comporte une électrovanne trois voies,
- l'éjecteur est multiétagé,
- le premier dispositif à vanne comporte au moins une électrovanne pilotable par le moyen de contrôle,
- la pompe à vide primaire sèche comporte une pluralité d'étages de pompage, le moyen de purge comporte une pluralité de branches pour distribuer le gaz de purge vers chacun des étages de pompage et le premier dispositif à vanne comporte une pluralité d'électrovannes, chaque électrovanne étant agencée sur une branche respective,
- le moyen de contrôle est configuré pour fermer au moins partiellement les électrovannes du premier dispositif à vanne associées aux étages de pompage autres que le premier étage de pompage et pour ouvrir l'électrovanne du premier dispositif à vanne du premier étage de pompage, lorsque la chambre de procédés est en fonctionnement de vide limite,
- le deuxième dispositif à vanne comporte une électrovanne pilotable par le moyen de contrôle,
- l'alimentation électrique de l'électrovanne est connectée à un commutateur de la chambre de procédés,
- le deuxième dispositif à vanne comporte un clapet anti-retour taré pour s'ouvrir lorsque l'éjecteur est mis en route et le moyen de contrôle est configuré pour mettre en route l'éjecteur en fonction de l'état de fonctionnement de la chambre de procédés.

La réduction du flux du gaz de purge dans les étages de pompage de la pompe à vide primaire sèche ainsi que l'abaissement de la pression à la sortie de la pompe à vide primaire sèche permettent d'obtenir une très basse pression de vide limite dans la chambre de procédés.

La réduction du flux du gaz de purge dans les étages de pompage de la pompe à vide primaire sèche lorsque la chambre de procédés est en fonctionnement de vide limite est possible car aucun gaz potentiellement contaminant pour la pompe à vide n'est introduit dans la chambre de procédés.

L'abaissement de la pression à la sortie de la pompe à vide primaire sèche permet en plus de réduire la consommation électrique de la pompe à vide primaire de façon substantielle.

Pour réduire encore les coûts énergétiques, on peut prévoir de mettre en route l'éjecteur uniquement lorsque la chambre de procédés est en fonctionnement de vide limite.

Par ailleurs, l'utilisation d'un éjecteur comme moyen de pompage auxiliaire permet un abaissement de la pression à la sortie de la pompe à vide primaire sèche sans utiliser de pièces mobiles, grâce à la détente du gaz moteur, donc sans consommation d'énergie électrique et de manière à n'occasionner ni usure ni entretien, ce qui n'est pas le cas par exemple d'une pompe à membrane ou à piston. Les éjecteurs présentent en plus l'avantage d'être très compacts de sorte que le dispositif de pompage peut conserver un faible encombrement. Egalement, ils résistent bien à la corrosion ou aux attaques de gaz agressifs, ce qui rend le dispositif de pompage très fiable. Les éjecteurs sont en outre peu coûteux.

L'abaissement de la pression à la sortie de la pompe à vide primaire sèche par un éjecteur est réalisé de manière judicieuse en alimentant le moyen d'injection de gaz moteur avec le gaz du moyen de purge de la pompe à vide primaire sèche. On profite ainsi de la disponibilité d'un gaz de purge comprimé généralement entre deux et trois bars, qui n'est plus utilisé pour alimenter le moyen de purge de la pompe à vide primaire sèche, pour alimenter l'éjecteur en gaz moteur.

### DESCRIPTION SOMMAIRE DES DESSINS

D'autres caractéristiques et avantages de la présente invention apparaîtront à la lecture de la description donnée à titre illustratif et non limitatif et des dessins sur lesquels :
- la figure 1 illustre de manière schématique un dispositif de pompage selon un premier mode de réalisation, raccordé à une chambre de procédés, sur cette figure 1, le moyen de pompage auxiliaire réalisé par une pompe à membrane ne fait pas partie de l'invention.
- la figure 2 illustre de manière schématique un dispositif de pompage selon un deuxième mode de réalisation, sur cette figure 2, le moyen de pompage auxiliaire réalisé par une pompe à membrane ne fait pas partie de l'invention.
- la figure 3 représente de manière schématique un dispositif de pompage selon un troisième mode de réalisation,
- la figure 4a montre schématiquement un éjecteur multiétagé en fonctionnement dans une première phase de pompage, pour laquelle un gaz moteur est injecté dans tous les étages de l'éjecteur,
- la figure 4b montre schématiquement un éjecteur multiétagé en fonctionnement dans une deuxième phase de pompage, pour laquelle un gaz moteur est injecté dans deux étages de l'éjecteur, et
- la figure 4c montre schématiquement un éjecteur multiétagé en fonctionnement dans une troisième phase de pompage, pour laquelle un gaz moteur est injecté dans un seul étage de l'éjecteur.

### DESCRIPTION DÉTAILLÉE

On définit par « vide limite », un état de fonctionnement de la chambre de procédés dans lequel aucun flux de gaz n'est introduit dans la chambre de procédés, excepté ceux d'éventuels flux de gaz parasites et négligeables par exemple dus aux flux de dégazage des parois ou dus à des flux de fuites, la chambre de procédés étant mise sous vide par le dispositif de pompage en fonctionnement.

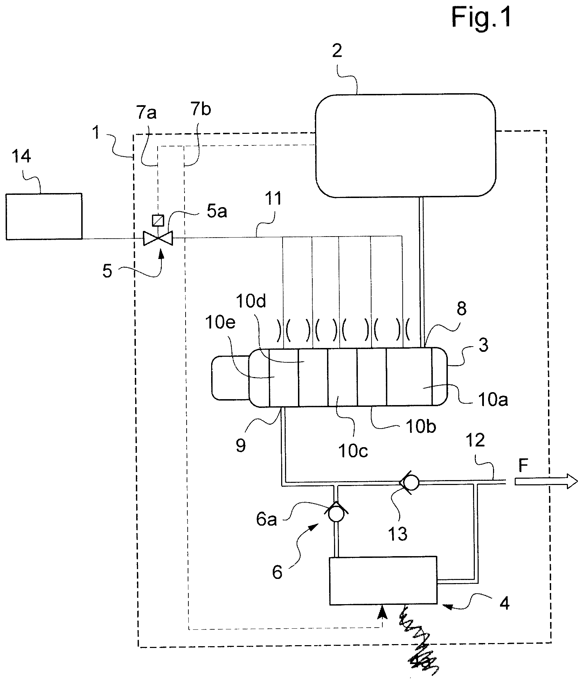

La figure 1 représente un dispositif de pompage 1 pour le pompage d'une chambre de procédés 2 d'un équipement de fabrication de semi-conducteurs. Le traitement mis en œuvre dans la chambre est par exemple un dépôt MOCVD (de l'anglais « Metal Organic Chemical Vapour Deposition ») qui est un dépôt chimique sous phase vapeur permettant notamment le dépôt d'une couche active de GaN sur un substrat de LED (de l'anglais « Light Emitting Diodes »). Les gaz introduits dans la chambre de procédé 2 au cours du traitement du substrat comportent du TMG (Tri-méthyl Galium), de l'NH₃ et de l'H₂ pour lesquels les flux de gaz de procédés sont compris entre 50 et 250 slm (soit entre 83,5 Pa.m³/s et 417,5 Pa.m³/s) et les pressions de procédés sont comprises entre 100 et 500 mbar.

La chambre de procédés 2 comporte un moyen d'information de son fonctionnement de vide limite indiquant qu'aucun gaz de procédés n'est introduit dans la chambre de procédés 2 et que celle-ci est mise sous vide par le dispositif de pompage 1. Cette information de fonctionnement de vide limite est par exemple un signal électrique, comme le contact électrique de la fermeture d'un commutateur.

Comme on peut le voir sur la figure 1, le dispositif de pompage 1 comporte une pompe à vide primaire sèche 3, un moyen de pompage auxiliaire 4, un premier et un deuxième dispositifs à vanne 5, 6 et un moyen de contrôle configuré pour contrôler le premier et le deuxième dispositifs à vanne 5, 6 en fonction d'un état de fonctionnement de la chambre de procédés 2.

La pompe à vide primaire sèche 3 comporte une entrée 8, une sortie 9, au moins un étage de pompage agencé entre l'entrée 8 et la sortie 9, un moyen de purge 11, un conduit de refoulement 12 raccordé à la sortie 9 de la pompe à vide 3 et un clapet antiretour 13 agencé dans le conduit de refoulement 12. L'entrée 8 de la pompe à vide 3 est raccordée à la sortie de la chambre de procédés 2.

La pompe à vide primaire sèche 3 est par exemple une pompe à vide multiétagée de type « Roots » et comporte une pluralité d'étages de pompage, cinq dans l'exemple 10a, 10b, 10c, 10d, 10e. L'entrée du premier étage de pompage 10a correspond à l'entrée 8 de la pompe à vide 3. Ce premier étage de pompage 10a est généralement appelé étage basse pression. Le dernier étage de pompage 10e débouche à la sortie 9 de la pompe à vide 3 qui refoule à la pression atmosphérique. Ce dernier étage de pompage 10e est généralement appelé étage haute pression. Des canaux inter-étages raccordent les étages de pompage 10a, 10b, 10c, 10d, 10e, en série les uns à la suite des autres. Plus précisément, les canaux inter-étages raccordent la sortie de l'étage de pompage qui précède à l'entrée de l'étage qui suit, entre l'entrée 8 et la sortie 9 de la pompe à vide 3.

Le moyen de purge 11 est configuré pour injecter un gaz de purge, tel que de l'azote, dans les étages de pompage 10a, 10b, 10c, 10d, 10e. Le moyen de purge 11 comprend un distributeur également appelé « clarinette », comportant autant de branches que la pompe à vide 3 comporte d'étages de pompage, pour distribuer le gaz de purge depuis une alimentation en gaz 14 vers chacun des cinq étages de pompage 10a, 10b, 10c, 10d, 10e. L'injection du moyen de purge 11 est en général réalisée en plusieurs points répartis le long des étages de pompage 10a, 10b, 10c, 10d, 10e à travers des gicleurs débouchant dans le refoulement de l'étage de pompage associé. Dans le premier et le dernier étages de pompage 10a, 10e, le gaz de purge est par exemple injecté au niveau des roulements de la pompe à vide 3. Le flux de gaz de purge est par exemple compris entre 35 et 100 slm (soit entre 58,45 Pa.m³/s et 167 Pa.m³/s).

Le gaz de purge permet de diluer les gaz provenant de la chambre de procédés 2, notamment pour garantir le maintien des jeux fonctionnels entre le stator et les rotors, ainsi qu'entre les lobes des rotors de la pompe à vide primaire sèche 3.

Le clapet antiretour 13 de la pompe à vide 3 permet d'imposer la circulation du gaz dans le sens de pompage (voir flèche F sur la figure 1) depuis la chambre de procédés 2 vers le conduit de refoulement 12 et d'éviter ainsi le retour du gaz pompé dans la pompe à vide 3. En fonctionnement, la pompe à vide 3 met la chambre de procédés 2 sous basse pression en comprimant et refoulant les gaz dans le conduit de refoulement 12 à travers le clapet antiretour 13. Lorsque la pression en sortie de pompe à vide 3 est inférieure à la pression de refoulement, le clapet antiretour 13 se ferme. On évite ainsi le retour de l'atmosphère dans la sortie 9.

Le premier dispositif à vanne 5 est interposé entre le moyen de purge 11 de la pompe à vide primaire sèche 3 et l'alimentation en gaz 14 auxquels il est raccordé.

Le moyen de contrôle peut être un ordinateur, un microcontrôleur ou un contrôleur muni d'un programme chargé de contrôler les éléments du dispositif de pompage pour l'exécution des étapes du procédé. Il est configuré pour fermer au moins partiellement le premier dispositif à vanne 5 lorsque la chambre de procédés est en fonctionnement de vide limite.

Selon un premier exemple, en position fermée, le premier dispositif à vanne 5 coupe totalement la circulation du gaz entre l'alimentation en gaz 14 et le moyen de purge 11, coupant ainsi l'alimentation en gaz du moyen de purge 11 dans au moins un étage de pompage 10a, 10b, 10c, 10d, 10e.

Selon un autre exemple, en position quasiment fermée, le premier dispositif à vanne 5 réduit considérablement l'alimentation en gaz 14 du moyen de purge 11 dans au moins un étage de pompage 10a, 10b, 10c, 10d, 10e. Ainsi, le flux d'alimentation en gaz 14 du moyen de purge 11 de l'ordre de 35 et 100 slm est réduit en fonctionnement de vide limite, à un flux compris entre 20 et 200 sccm (soit entre 0,0334 et 0,334 Pa.m³/s).

Le flux de purge résiduel que laisse passer le premier dispositif à vanne 5 est donc négligeable par rapport au flux de purge nécessaire pour diluer les gaz de procédés. Ce flux de purge résiduel, en permanence prélevé sur l'alimentation en gaz 14, permet d'imposer un sens d'écoulement des gaz dans le moyen de purge 11 afin d'empêcher l'accumulation d'éventuels résidus de gaz corrosifs en provenance de la chambre de procédé 2 dans le moyen de purge 11.

Le premier dispositif à vanne 5 comporte par exemple au moins une électrovanne 5a interposée entre le moyen de purge 11 de la pompe à vide primaire sèche 3 et l'alimentation en gaz 14.

Le moyen de contrôle est par exemple réalisé par le câblage de l'alimentation électrique de l'électrovanne 5a. L'alimentation électrique est par exemple connectée à un commutateur de la chambre de procédés 2 par un premier raccord électrique 7a. Lorsque la chambre de procédés 2 est en fonctionnement de vide limite, la fermeture du commutateur coupe l'alimentation électrique de l'électrovanne 5a provoquant sa fermeture afin de réduire ou couper complétement l'alimentation en gaz du moyen de purge 11 de la pompe à vide primaire sèche 3.

D'autres formes de réalisation du moyen de contrôle de l'électrovanne 5a peuvent bien sûr être envisagées, par exemple par le câblage de l'alimentation pneumatique de l'électrovanne 5a.

Dans le premier mode de réalisation de la figure 1, le premier dispositif à vanne 5 est agencé sur un tronc commun de la clarinette du moyen de purge 11 reliant toutes les branches de la pompe à vide primaire sèche 3. Il réduit ou coupe ainsi l'alimentation en gaz 14 dans tous les étages de pompage 10a, 10b, 10c, 10d, 10e à la fois.

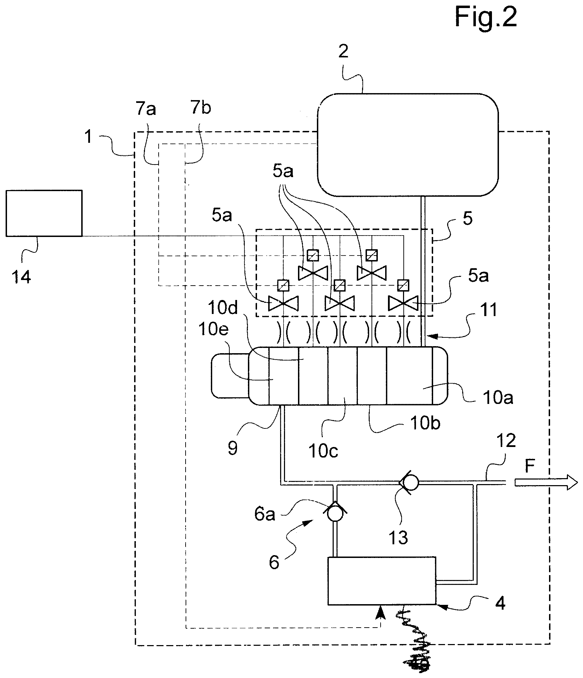

Selon un autre exemple représenté sur la figure 2, le premier dispositif à vanne 5 est configuré pour alimenter sélectivement les étages de pompage 10a, 10b, 10c, 10d, 10e en gaz de purge. Par exemple, le premier dispositif à vanne 5 comporte autant d'électrovannes 5a que le moyen de purge 11 comporte de branches, chaque électrovanne 5a étant agencée sur une branche respective du moyen de purge 11, de manière à sélectivement réduire ou couper l'alimentation en gaz 14 d'un ou de plusieurs étages de pompage 10a, 10b, 10c, 10d, 10e à la fois.

Le moyen de contrôle est par exemple configuré pour fermer au moins partiellement les électrovannes 5a du premier dispositif à vanne 5 associées aux étages de pompage 10b, 10c, 10d, 10e autres que le premier étage de pompage 10a et pour ouvrir l'électrovanne 5a du premier dispositif à vanne 5 du premier étage de pompage 10a, lorsque la chambre de procédés 2 est en fonctionnement de vide limite. Le gaz de purge est ainsi réduit ou coupé dans les étages de pompage 10b, 10c, 10d, 10e autres que le premier étage de pompage 10a tandis qu'un flux de gaz de purge est préservé dans l'étage de pompage de basse pression 10a. Ce flux de purge permet d'assurer une protection minimale des étages de pompage de la pompe à vide 3.

Le moyen de contrôle est également configuré pour ouvrir le deuxième dispositif à vanne 6 lorsque la chambre de procédés 2 est en fonctionnement de vide limite.

Comme on peut le voir sur les figures 1 et 2, le moyen de pompage auxiliaire 4 du dispositif de pompage 1 est monté en dérivation du clapet anti-retour 13 de la pompe à vide 3.

Le deuxième dispositif à vanne 6 est monté en dérivation du clapet anti-retour 13, en série avec le moyen de pompage auxiliaire 4, en amont de ce dernier.

Lorsque la chambre de procédés 2 n'est pas en fonctionnement de vide limite, le deuxième dispositif à vanne 6 en position fermée isole l'entrée du moyen de pompage auxiliaire 4 du conduit de refoulement 12 et le premier dispositif à vanne 5 est ouvert, alimentant en gaz le moyen de purge des étages de pompage 10a, 10b, 10c, 10d et 10e.

L'information de fonctionnement en vide limite de la chambre de procédés 2 provoque l'ouverture du deuxième dispositif à vanne 6 et la fermeture au moins partielle du premier dispositif à vanne 5, coupant ou réduisant l'alimentation en gaz du moyen de purge 11 de la pompe à vide primaire sèche 3 et mettant le moyen de pompage auxiliaire 4 en communication fluidique avec le conduit de refoulement 12.

La réduction du flux du gaz de purge dans les étages de pompage de la pompe à vide primaire sèche 3 ainsi que l'abaissement de la pression à la sortie 9 de la pompe à vide primaire sèche 3 permettent d'obtenir une très basse pression d'aspiration à l'entrée 8 de la pompe à vide primaire sèche 3 et donc, une très basse pression de vide limite dans la chambre de procédés 2. On peut ainsi baisser la pression limite dans la chambre de procédés 2 d'un facteur dix.

Pour réduire les coûts énergétiques, on peut en plus prévoir de mettre en route le moyen de pompage auxiliaire 4 uniquement lorsque la chambre de procédés 2 est en fonctionnement de vide limite.

Selon un premier exemple représenté sur la figure 1, le deuxième dispositif à vanne 6 comporte un clapet anti-retour 6a taré pour s'ouvrir lorsque le moyen de pompage auxiliaire 4 est mis en route. Le moyen de contrôle est configuré pour mettre en route le moyen de pompage auxiliaire 4 lorsque la chambre de procédés 2 est en fonctionnement de vide limite.

Le moyen de pompage auxiliaire 4 est par exemple mis en route dès qu'il est électriquement alimenté. L'alimentation électrique du moyen de pompage auxiliaire 4 est alors par exemple connectée au moyen d'information de la chambre de procédés 2 par un deuxième raccord électrique 7b.

Les Figures 1 et 2 montrent un exemple qui ne fait pas partie de l'invention et pour lequel le moyen de pompage auxiliaire 4 est une pompe à membrane 4a.En position fermée, le clapet anti-retour 6a isole l'entrée du moyen de pompage auxiliaire 4 du conduit de refoulement 12. Le fonctionnement de vide limite de la chambre de procédés 2 provoque la fermeture d'un contact électrique entraînant l'alimentation électrique du moyen de pompage auxiliaire 4 et donc, sa mise en route. Le clapet anti-retour 6a s'ouvre automatiquement lorsque le moyen de pompage auxiliaire 4 est mis en route, la dépression créée en aval du clapet anti-retour 6a le faisant s'ouvrir.

Le moyen de contrôle du premier dispositif à vanne 6 est ainsi automatique et ne nécessite pas de raccord électrique avec la chambre de procédés 2.

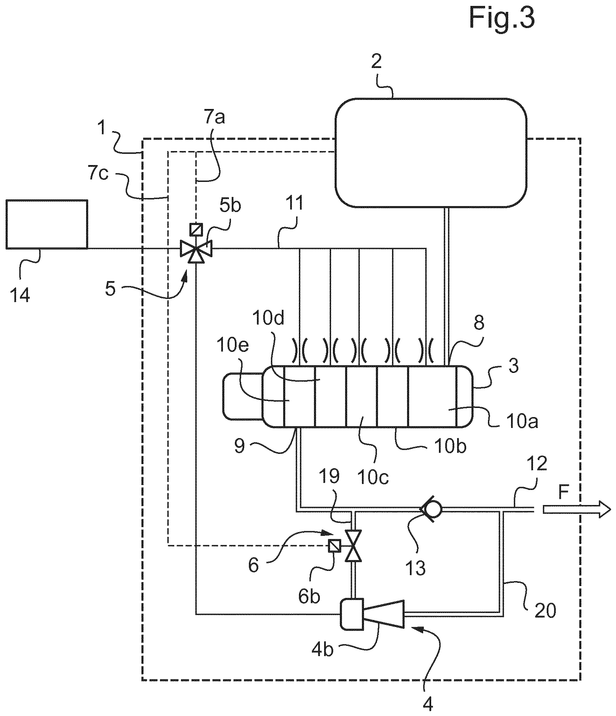

Selon le mode de réalisation de la figure 3, le moyen de contrôle du deuxième dispositif à vanne 6 comporte une électrovanne 6b.

Le moyen de contrôle est configuré pour ouvrir l'électrovanne 6b du deuxième dispositif à vanne 6 lorsque la chambre de procédés 2 est en fonctionnement de vide limite, mettant ainsi le moyen de pompage auxiliaire 4 en communication avec le conduit de refoulement 12.

Par exemple, l'alimentation électrique de l'électrovanne 6b est connectée au moyen d'information de la chambre de procédés 2 par un troisième raccord électrique 7c. La fermeture du commutateur du moyen d'information de la chambre de procédés 2 permet alors d'alimenter l'électrovanne 6b provoquant son ouverture.

Selon l'invention et comme représenté sur la figure 3, le moyen de pompage auxiliaire 4 comporte un éjecteur 4b.

L'éjecteur 4b comporte une conduite 22 et un moyen d'injection de gaz moteur.

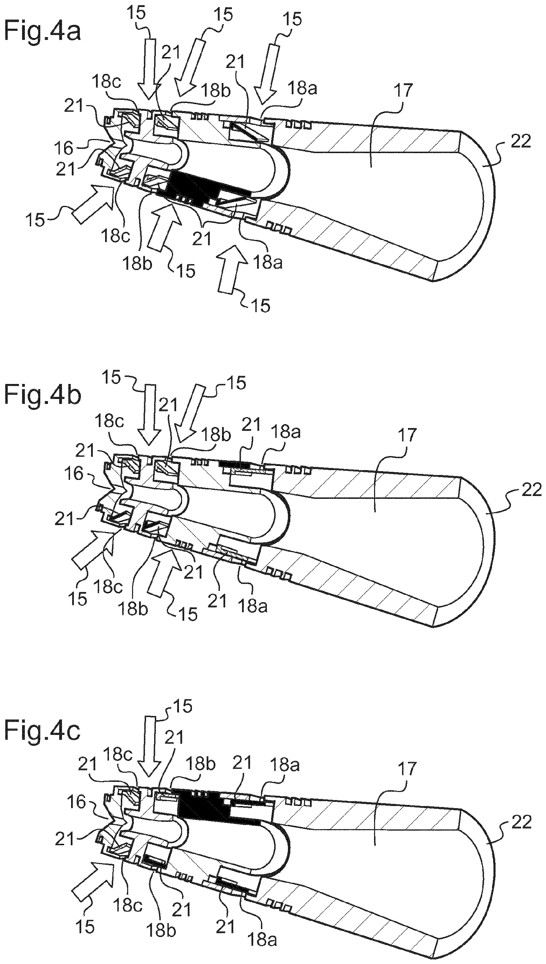

Mieux visible sur les figures 4a, 4b, 4c, la conduite 22 comporte un orifice d'aspiration 16, un orifice de refoulement 17 et au moins une buse d'entrée 18a, 18b, 18c débouchant dans l'espace intérieur de la conduite 22. L'orifice d'aspiration 16 et l'orifice de refoulement 17 sont respectivement reliés au conduit de refoulement 12 par des première 19 et deuxième 20 canalisations (figure 3). Le moyen d'injection de gaz moteur est configuré pour piloter l'injection d'un gaz moteur sous pression, à grande vitesse, dans au moins une buse d'entrée 18a, 18b, 18c.

Dans l'exemple illustré, l'éjecteur 4b est multiétagé, c'est-à-dire qu'il comporte plusieurs buses d'entrées 18a, 18b, 18c, réparties le long de la conduite 22 entre l'orifice d'aspiration 16 et l'orifice de refoulement 17, définissant plusieurs étages. L'éjecteur 4b comporte par exemple trois étages, chaque étage étant défini par deux buses d'entrées 18a, 18b, 18c en vis-à-vis. Les buses d'entrées 18a, 18b, 18c sont par exemple régulièrement reparties deux par deux le long de la conduite 22. Selon la pression et le débit recherchés, on injecte le gaz moteur vers aucun, un ou plusieurs étages de l'éjecteur 4b. L'activation simultanée de plusieurs étages par l'injection du gaz moteur permet d'augmenter le débit de pompage de l'éjecteur 4b. L'éjecteur 4b comporte également un clapet 21, par exemple pivotant, associé à chaque buse d'entrée 18a, 18b, 18c, pour obturer ladite buse d'entrée lorsqu'aucun gaz moteur n'est injecté.

L'éjecteur est un moyen de pompage qui fonctionne à partir du principe de l'effet Venturi : phénomène de la dynamique des fluides où les particules gazeuses ou liquides se retrouvent accélérées à cause d'un rétrécissement de leur zone de circulation, l'aspiration se produisant au niveau de l'étranglement. Lorsque le gaz comprimé passe au travers des buses d'entrées 18a, 18b, 18c, une aspiration a lieu au travers de chaque étage.

Le moyen d'injection de gaz moteur comporte un réseau de distribution de gaz moteur 15 pour injecter sélectivement un gaz moteur vers chaque buse d'entrée 18a, 18b, 18c. Le moyen d'injection de gaz moteur peut sélectivement piloter l'injection du gaz moteur dans aucun, un ou plusieurs étages de l'éjecteur 4b.

Sur l'exemple de la figure 4a, le moyen d'injection de gaz moteur pilote l'injection du gaz moteur dans tous les étages de l'éjecteur 4b tandis que sur la figure 4b, le moyen d'injection de gaz pilote l'injection de gaz moteur seulement dans les deux derniers étages de l'éjecteur 4b, puis uniquement dans le dernier étage de l'éjecteur 4b sur la figure 4c.

Lorsque la chambre de procédés 2 est en fonctionnement de vide limite, le moyen de contrôle ferme au moins partiellement le premier dispositif à vanne 5 et ouvre le deuxième dispositif à vanne 6 mettant l'éjecteur 4b en communication fluidique avec le conduit de refoulement 12.

La réduction ou la coupure du gaz dans le moyen de purge de la pompe à vide primaire sèche 3 et l'abaissement de la pression en sortie 9 de la pompe à vide primaire sèche 3 permettent d'abaisser le seuil de la pression limite dans la chambre de procédés 2.

Par ailleurs, l'utilisation d'un éjecteur 4b comme moyen de pompage auxiliaire 4 permet un abaissement de la pression à la sortie 9 de la pompe à vide primaire sèche 3 sans utiliser de pièces mobiles, grâce à la détente du gaz moteur, donc sans consommation d'énergie électrique et de manière à n'occasionner ni usure ni entretien, ce qui n'est pas le cas par exemple d'une pompe à membrane ou à piston.

Les éjecteurs présentent en plus l'avantage d'être très compacts de sorte que le dispositif de pompage peut conserver un faible encombrement. Egalement, ils résistent bien à la corrosion ou aux attaques de gaz agressifs, ce qui rend le dispositif de pompage très fiable. Les éjecteurs sont en outre peu coûteux.

Pour réduire les coûts énergétiques, on peut prévoir de mettre en route l'éjecteur 4b uniquement lorsque la chambre de procédés 2 est en fonctionnement de vide limite.

Cela peut être réalisé de manière judicieuse en alimentant le moyen d'injection de gaz moteur de l'éjecteur 4b avec le gaz du moyen de purge 11 de la pompe à vide primaire sèche 3. On profite ainsi de la disponibilité du gaz de purge, comprimé généralement entre deux et trois bars, qui n'est pratiquement plus utilisé pour alimenter le moyen de purge 11 de la pompe à vide primaire sèche 3, pour alimenter l'éjecteur 4b en gaz moteur.

Pour cela, le premier dispositif à vanne 5 est également raccordé au moyen d'injection de gaz moteur de l'éjecteur 4b et le premier dispositif à vanne 5 est configuré pour basculer l'alimentation en gaz 14 du moyen de purge 11 de la pompe à vide primaire sèche 3 vers le moyen d'injection de gaz moteur de l'éjecteur 4b.

Par exemple, le premier dispositif à vanne 5 comporte deux électrovannes deux voies. Une première électrovanne comporte une première voie raccordée au moyen de purge 11 de la pompe à vide primaire sèche 3 et une deuxième voie est raccordée à l'alimentation en gaz 14. Une deuxième électrovanne comporte une première voie raccordée au moyen d'injection de gaz moteur de l'éjecteur 4b et une deuxième voie est raccordée à l'alimentation en gaz 14.

Le moyen de contrôle du premier dispositif à vanne 5 est par exemple réalisé par le câblage des alimentations électriques des électrovannes.

Selon un deuxième exemple de réalisation, le premier dispositif à vanne 5 comporte une vanne trois voies 5b, telle qu'une électrovanne trois voies, une première voie étant raccordée au moyen de purge 11 de la pompe à vide primaire sèche 3, une deuxième voie étant raccordée à l'alimentation en gaz 14, et une troisième voie étant raccordée au moyen d'injection de gaz moteur de l'éjecteur 4b. Ainsi, le contrôle du basculement de l'alimentation en gaz 14 de la pompe à vide primaire sèche 3 vers le moyen d'injection de gaz moteur de l'éjecteur 4b, est simplifié.

Le deuxième dispositif à vanne 6 peut comporter un clapet anti-retour 6a taré pour s'ouvrir automatiquement lorsque l'éjecteur 4b est mis en route. Le moyen de contrôle est configuré pour mettre en route l'éjecteur 4b, c'est-à-dire injecter le gaz moteur dans au moins une buse d'entrée 18a, 18b, 18c, lorsque la chambre de procédés 2 est en fonctionnement de vide limite.

Alternativement, le deuxième dispositif à vanne 6 peut comporter une électrovanne 6b (figure 3).

Par ailleurs, le deuxième dispositif à vanne 6 peut être configuré pour s'ouvrir à la réception de l'information de fonctionnement de vide limite de la chambre de procédés 2 et se refermer après une durée prédéterminée, par exemple de l'ordre de trois secondes. L'injection de gaz moteur par le moyen d'injection de gaz moteur est alors pilotée pendant un temps très court sur l'information de la chambre de procédés 2 en fonctionnement de vide limite. En effet, la baisse de pression provoquée par la mise en route de l'éjecteur 4b peut se maintenir indéfiniment tant que la ligne de pompage est en fonctionnement de vide limite et n'est pas réalimentée avec un nouvel afflux gazeux. L'alimentation en gaz moteur de l'éjecteur 4b occasionnelle et ponctuelle permet d'optimiser encore la consommation en azote.

Ainsi, lorsque le deuxième dispositif à vanne 6 est fermé, aucun gaz moteur n'est injecté, les clapets 21 sont fermés et isolent l'espace intérieur de la conduite 22 de l'éjecteur 4b.

Lorsque la chambre de procédés 2 est en fonctionnement de vide limite, le moyen de contrôle ferme au moins partiellement le premier dispositif à vanne 5 et bascule l'alimentation du gaz de purge vers une ou plusieurs entrée(s) 18a, 18b, 18c de l'éjecteur 4b.

Le clapet 21 associé s'ouvre faisant pénétrer le gaz moteur dans l'éjecteur 4b, ce qui produit une baisse de la pression dans la conduite 22 en communication avec le conduit de refoulement 12 et donc un abaissement de la pression en sortie 9 de la pompe à vide 3.

Le dispositif de pompage 1 permet donc d'obtenir facilement et à moindre coût une pression basse de vide limite, ainsi que des vitesses de pompage satisfaisantes pour le traitement des substrats à basse pression.

## Revendications

1. Dispositif de pompage destiné à être raccordé à une chambre de procédés (2) comportant :
- une pompe à vide primaire sèche (3) présentant :
_{∘} une entrée (8) et une sortie (9),
∘ au moins un étage de pompage (10a, 10b, 10c, 10d, 10e) agencé entre l'entrée (8) et la sortie (9),
∘ un moyen de purge (11) configuré pour injecter un gaz de purge dans ledit étage de pompage (10a, 10b, 10c, 10d, 10e),
∘ un conduit de refoulement (12) raccordé à la sortie (9),
∘ un clapet antiretour (13) agencé dans le conduit de refoulement (12),
- un éjecteur (4b), monté en dérivation du clapet anti-retour (13), l'éjecteur (4b) comprenant :
- une conduite (22) présentant un orifice d'aspiration (16), un orifice de refoulement (17), et au moins une buse d'entrée (18a, 18b, 18c), et
- un moyen d'injection de gaz moteur pour piloter l'injection d'un gaz moteur dans au moins une buse d'entrée (18a, 18b, 18c),
**caractérisé en ce que** le dispositif de pompage comporte :
- un premier dispositif à vanne (5) raccordé au moyen de purge (11) de la pompe à vide primaire sèche (3) et destiné à être raccordé à une alimentation en gaz (14),
- un deuxième dispositif à vanne (6) monté en dérivation du clapet anti-retour (13), en amont de l'éjecteur (4b),
- un moyen de contrôle configuré pour contrôler le premier et le deuxième dispositifs à vanne (5, 6) en fonction d'un état de fonctionnement de la chambre de procédés (2), le premier dispositif à vanne (5) raccordé au moyen de purge (11) étant également raccordé au moyen d'injection de gaz moteur et étant configuré pour basculer au moins partiellement l'alimentation en gaz (14) du moyen de purge (11) de la pompe à vide primaire sèche (3) vers le moyen d'injection de gaz moteur de l'éjecteur (4b).

2. Dispositif de pompage selon l'une des revendications précédentes, **caractérisé en ce que** le premier dispositif à vanne (5) comporte une électrovanne trois voies (5b).

3. Dispositif de pompage selon l'une des revendications précédentes, **caractérisé en ce que** l'éjecteur (4b) est multiétagé.

4. Dispositif de pompage selon l'une des revendications précédentes, **caractérisé en ce que** le premier dispositif à vanne (5) comporte au moins une électrovanne (5a, 5b) pilotable par le moyen de contrôle.

5. Dispositif de pompage selon la revendication précédente, dans lequel la pompe à vide primaire sèche (3) comporte une pluralité d'étages de pompage (10a, 10b, 10c, 10d, 10e), le moyen de purge (11) comporte une pluralité de branches pour distribuer le gaz de purge vers chacun des étages de pompage (10a, 10b, 10c, 10d, 10e) et le premier dispositif à vanne (5) comporte une pluralité d'électrovannes (5a), chaque électrovanne (5a) étant agencée sur une branche respective.

6. Dispositif de pompage selon la revendication précédente, **caractérisé en ce que** le moyen de contrôle est configuré pour fermer au moins partiellement les électrovannes (5a) du premier dispositif à vanne (5) associées aux étages de pompage (10b, 10c, 10d, 10e) autres que le premier étage de pompage (10a) et pour ouvrir l'électrovanne (5a) du premier dispositif à vanne (5) du premier étage de pompage (10a), lorsque la chambre de procédés (2) est en fonctionnement de vide limite.

7. Dispositif de pompage selon l'une des revendications précédentes, **caractérisé en ce que** le deuxième dispositif à vanne (6) comporte une électrovanne (6b) pilotable par le moyen de contrôle.

8. Dispositif de pompage selon l'une des revendications 4 à 7, **caractérisée en ce que** l'alimentation électrique de l'électrovanne (5a, 5b, 6b) est connectée à un commutateur de la chambre de procédés (2).

9. Dispositif de pompage selon l'une des revendications 1 à 6, **caractérisé en ce que** le deuxième dispositif à vanne (6) comporte un clapet anti-retour (6a) taré pour s'ouvrir lorsque l'éjecteur (4b) est mis en route.

10. Procédé de pompage d'une chambre de procédés au moyen d'un dispositif de pompage (1) selon l'une des revendications précédentes raccordé à une chambre de procédés, **caractérisé en ce qu'**on réduit l'alimentation en gaz du moyen de purge (11) de la pompe à vide primaire sèche (3) et on abaisse la pression dans le conduit de refoulement (12) raccordé à la sortie (9) de la pompe à vide primaire sèche (3), par la mise en route de l'éjecteur (4b) lorsque la chambre de procédés (2) est en fonctionnement de vide limite, en alimentant le moyen d'injection de gaz moteur de l'éjecteur (4b) avec le gaz du moyen de purge (11) de la pompe à vide primaire sèche (3).

11. Procédé de pompage selon la revendication précédente, **caractérisé en ce qu'**on met en route l'éjecteur (4b) uniquement lorsque la chambre de procédés (2) est en fonctionnement de vide limite.

12. Procédé de pompage selon l'une des revendications 10 ou 11, **caractérisé en ce que** lorsque la chambre de procédés (2) est en fonctionnement de vide limite, le flux d'alimentation en gaz (14) du moyen de purge (11) est compris entre 0,0334 Pa.m³/s et 0,334Pa.m³/s.

## Patentansprüche

1. Pumpvorrichtung, die dazu bestimmt ist, an einen Verfahrensraum (2) angeschlossen zu werden, die aufweist:
- eine trockenlaufende Primärvakuumpumpe (3), die aufweist:
∘ einen Eingang (8) und einen Ausgang (9),
∘ mindestens eine Pumpstufe (10a, 10b, 10c, 10d, 10e), die zwischen dem Eingang (8) und dem Ausgang (9) angeordnet ist,
∘ eine Spüleinrichtung (11), die konfiguriert ist, ein Spülgas in die Pumpstufe (10a, 10b, 10c, 10d, 10e) einzuspritzen,
∘ einen an den Ausgang (9) angeschlossenen Förderkanal (12),
∘ ein im Förderkanal (12) angeordnetes Rückschlagventil (13),
- einen Ejektor (4b), der in Abzweigung vom Rückschlagventil (13) montiert ist, wobei der Ejektor (4b) aufweist :
- eine Leitung (22), die eine Ansaugöffnung (16), eine Förderöffnung (17) und mindestens eine Eingangsdüse (18a, 18b, 18c) aufweist, und
- eine Einspritzeinrichtung von Antriebsgas, um das Einspritzen eines Antriebsgases in mindestens eine Eingangsdüse (18a, 18b, 18c) zu steuern,
**dadurch gekennzeichnet, dass** die Pumpvorrichtung aufweist:
- eine erste Ventilvorrichtung (5), die an die Spüleinrichtung (11) der trockenlaufenden Primärvakuumpumpe (3) angeschlossen und dazu bestimmt ist, an eine Gasversorgung (14) angeschlossen zu werden,
- eine zweite Ventilvorrichtung (6), die in Abzweigung vom Rückschlagventil (13) stromaufwärts vor dem Ejektor (4b) montiert ist,
- eine Steuereinrichtung, die konfiguriert ist, die erste und die zweite Ventilvorrichtung (5, 6) abhängig von einem Betriebszustand des Verfahrensraums (2) zu steuern, wobei die an die Spüleinrichtung (11) angeschlossene erste Ventilvorrichtung (5) ebenfalls an die Einspritzeinrichtung von Antriebsgas angeschlossen und konfiguriert ist, die Gasversorgung (14) der Spüleinrichtung (11) der trockenlaufenden Primärvakuumpumpe (3) zumindest teilweise zur Einspritzeinrichtung von Antriebsgas des Ejektors (4b) umzuschalten.

2. Pumpvorrichtung nach einem der vorhergehenden Ansprüche, **dadurch gekennzeichnet, dass** die erste Ventilvorrichtung (5) ein Dreiwege-Elektroventil (5b) aufweist.

3. Pumpvorrichtung nach einem der vorhergehenden Ansprüche, **dadurch gekennzeichnet, dass** der Ejektor (4b) mehrstufig ist.

4. Pumpvorrichtung nach einem der vorhergehenden Ansprüche, **dadurch gekennzeichnet, dass** die erste Ventilvorrichtung (5) mindestens ein von der Steuereinrichtung steuerbares Elektroventil (5a, 5b) aufweist.

5. Pumpvorrichtung nach dem vorhergehenden Anspruch, wobei die trockenlaufende Primärvakuumpumpe (3) eine Vielzahl von Pumpstufen (10a, 10b, 10c, 10d, 10e) aufweist, die Spüleinrichtung (11) eine Vielzahl von Zweigen aufweist, um das Spülgas zu jeder der Pumpstufen (10a, 10b, 10c, 10d, 10e) zu verteilen, und die erste Ventilvorrichtung (5) eine Vielzahl von Elektroventilen (5a) aufweist, wobei jedes Elektroventil (5a) auf einem jeweiligen Zweig angeordnet ist.

6. Pumpvorrichtung nach dem vorhergehenden Anspruch, **dadurch gekennzeichnet, dass** die Steuereinrichtung konfiguriert ist, die Elektroventile (5a) der ersten Ventilvorrichtung (5), die den anderen Pumpstufen (10b, 10c, 10d, 10e) als der ersten Pumpstufe (10a) zugeordnet sind, zumindest teilweise zu schließen, und das Elektroventil (5a) der ersten Ventilvorrichtung (5) der ersten Pumpstufe (10a) zu öffnen, wenn der Verfahrensraum (2) im Grenzvakuumbetrieb ist.

7. Pumpvorrichtung nach einem der vorhergehenden Ansprüche, **dadurch gekennzeichnet, dass** die zweite Ventilvorrichtung (6) ein Elektroventil (6b) aufweist, das von der Steuereinrichtung gesteuert werden kann.

8. Pumpvorrichtung nach einem der Ansprüche 4 bis 7, **dadurch gekennzeichnet, dass** die Stromversorgung des Elektroventils (5a, 5b, 6b) mit einem Schalter des Verfahrensraums (2) verbunden ist.

9. Pumpvorrichtung nach einem der Ansprüche 1 bis 6, **dadurch gekennzeichnet, dass** die zweite Ventilvorrichtung (6) ein Rückschlagventil (6a) aufweist, das tariert ist, sich zu öffnen, wenn der Ejektor (4b) in Betrieb genommen wird.

10. Pumpverfahren eines Verfahrensraums mittels einer an einen Verfahrensraum angeschlossenen Pumpvorrichtung (1) nach einem der vorhergehenden Ansprüche, **dadurch gekennzeichnet, dass** durch die Inbetriebnahme des Ejektors (4b), wenn der Verfahrensraum (2) im Grenzvakuumbetrieb ist, die Gasversorgung der Spüleinrichtung (11) der trockenlaufenden Primärvakuumpumpe (3) reduziert und der Druck im an den Ausgang (9) der trockenlaufenden Primärvakuumpumpe (3) angeschlossenen Förderkanal (12) gesenkt wird, indem die Einspritzeinrichtung von Antriebsgas des Ejektors (4b) mit dem Gas der Spüleinrichtung (11) der trockenlaufenden Primärvakuumpumpe (3) versorgt wird.

11. Pumpverfahren nach dem vorhergehenden Anspruch, **dadurch gekennzeichnet, dass** der Ejektor (4b) nur in Betrieb genommen wird, wenn der Verfahrensraum (2) im Grenzvakuumbetrieb ist.

12. Pumpverfahren nach einem der Ansprüche 10 oder 11, **dadurch gekennzeichnet, dass**, wenn der Verfahrensraum (2) im Grenzvakuumbetrieb ist, der Gasversorgungsstrom (14) der Spüleinrichtung (11) zwischen 0,0334 Pa.m³/s und 0,334Pa.m³/s liegt.

## Claims

1. Pumping device intended to be connected to a processing chamber (2), comprising:
- a dry primary vacuum pump (3) having:
∘ an inlet (8) and an outlet (9),
∘ at least one pumping stage (10a, 10b, 10c, 10d, 10e) arranged between the inlet (8) and the outlet (9),
∘ a purging means (11) configured to inject a purging gas into said pumping stage (10a, 10b, 10c, 10d, 10e),
∘ an exhaust duct (12) connected to the outlet (9), and
∘ an anti-return valve (13) arranged in the exhaust duct (12),
- an ejector (4b) mounted on a line bypassing the anti-return valve (13), the ejector (4b) comprising:
- a duct (22) having a suction orifice (16), an exhaust orifice (17), and at least one inlet nozzle (18a, 18b, 18c), and
- a means for injecting motive gas for controlling the injection of a motive gas into at least one inlet nozzle (18a, 18b, 18c),
**characterized in that** the pumping device comprises:
- a first valve-comprising device (5) connected to the purging means (11) of the dry primary vacuum pump (3) and intended to be connected to a gas supply (14),
- a second valve-comprising device (6) mounted on a line bypassing the anti-return valve (13) upstream of the ejector (4b),
- a controlling means configured to control the first and second valve-comprising devices (5, 6) depending on an operating state of the processing chamber (2), the first valve-comprising device (5) connected to the purging means (11) also being connected to the means for injecting motive gas and being configured to switch, at least partially, the gas supply (14) from the purging means (11) of the dry primary vacuum pump (3) to the means for injecting motive gas of the ejector (4b).

2. Pumping device according to Claim 1, **characterized in that** the first valve-comprising device (5) comprises a three-way solenoid valve (5b).

3. Pumping device according to one of the preceding claims, **characterized in that** the ejector (4b) is a multistage ejector.

4. Pumping device according to one of the preceding claims, **characterized in that** the first valve-comprising device (5) comprises at least one solenoid valve (5a, 5b) controllable by the controlling means.

5. Pumping device according to the preceding claim, wherein the dry primary vacuum pump (3) comprises a plurality of pumping stages (10a, 10b, 10c, 10d, 10e), the purging means (11) comprises a plurality of branches for distributing the purging gas to each of the pumping stages (10a, 10b, 10c, 10d, 10e), and the first valve-comprising device (5) comprises a plurality of solenoid valves (5a), each solenoid valve (5a) being arranged in a respective branch.

6. Pumping device according to the preceding claim, **characterized in that** the controlling means is configured to at least partially close those solenoid valves (5a) of the first valve-comprising device (5) that are associated with pumping stages (10b, 10c, 10d, 10e) other than the first pumping stage (10a) and to open the solenoid valve (5a) of the first valve-comprising device (5) of the first pumping stage (10a) when the processing chamber (2) is in vacuum limit operation.

7. Pumping device according to one of the preceding claims, **characterized in that** the second valve-comprising device (6) comprises a solenoid valve (6b) controllable by the controlling means.

8. Pumping device according to one of Claims 4 to 7, **characterized in that** the power supply of the solenoid valve (5a, 5b, 6b) is connected to a switch of the processing chamber (2).

9. Pumping device according to one of Claims 1 to 6, **characterized in that** the second valve-comprising device (6) comprises a calibrated anti-return valve (6a) that opens when the ejector (4b) is started up.

10. Method for pumping a processing chamber by means of a pumping device (1) according to one of the preceding claims, connected to a processing chamber, **characterized in that** the gas supply to the purging means (11) of the dry primary vacuum pump (3) is decreased and the pressure in the exhaust duct (12) connected to the outlet (9) of the dry primary vacuum pump (3) is reduced by starting up the ejector (4b) when the processing chamber (2) is in vacuum limit operation, the means for injecting motive gas of the ejector (4b) being supplied with gas from the purging means (11) of the dry primary vacuum pump (3).

11. Pumping method according to the preceding claim, **characterized in that** the ejector (4b) is started up only when the processing chamber (2) is in vacuum limit operation.

12. Pumping method according to either of Claims 10 and 11, **characterized in that**, when the processing chamber (2) is in vacuum limit operation, the flow rate of the gas supply (14) to the purging means (11) is comprised between 0.0334 Pa.m³/s and 0.334 Pa.m³/s.
